# EUROPEAN PATENT SPECIFICATION

(11) **EP 2 057 675 B1**
(45) Date of publication and mention of the grant of the patent: **29.09.2010**
(21) Application number: 07837483.2
(22) Date of filing: 29.08.2007
(51) Int. Cl.: H01L 21/762

(54) **IMPLANT AT SHALLOW TRENCH ISOLATION CORNER**
IMPLANTAT IN DER ECKE EINER FLACHEN GRABENISOLATION
IMPLANT AU NIVEAU D'UN ANGLE D'ISOLATION PAR TRANCHÉE PEU PROFONDE

(30) Priority: 01.09.2006 US 842075 P; 17.08.2007 US 840299
(43) Date of publication of application: 13.05.2009
(73) Proprietor: Eastman Kodak Company, Rochester NY 14650-2201 (US)
(72) Inventor: DOAN, Hung, Quoc, Rochester, NY 14612 (US); STEVENS, Eric, Gordon, Webster, NY 14580 (US)
(74) Representative: Weber, Etienne Nicolas
(86) International application number: PCT/US2007/018997
(87) International publication number: WO 2008/030371

(56) References cited:
- WO-A-97/36323
- US-A- 5 891 787
- US-A- 6 030 882
- US-A- 6 150 235
- US-A1- 2006 024 909

## Description

### TECHNICAL FIELD

The present invention generally relates to a method of fabricating an integrated circuit in a semiconductor device. More particularly, the present invention relates to fabricating an implant at the shallow trench isolation corner of an image sensor to suppress the surface dark current.

### BACKGROUND

Typically metallic or lattice defects, surface states, and lattice stress produce dark current in image sensors. Dark current is an undesirable signal that is generated in a semiconductor substrate and collected by a photodetector. Dark current is generated when light is both striking and not striking the photodetector. Dark current adds noise, which reduces the dynamic range and the signal-to-noise ratio of the image sensor.

Shallow trench isolation physically isolates pixels so that signal collected in any given pixel will not spill over to the neighboring pixel or pixels. Unfortunately, STI features can potentially produce surface dark current because the features create additional surface states and localized high stress regions. Image sensors, such as Complementary Metal Oxide Semiconductor (CMOS) image sensors, with STI regions suffer from high surface dark current at the sidewalls and bottom of the STI trench. Typically, high angle implants are performed on the sides and bottom of the STI regions to reduce the surface dark current. Additionally, corner implants further suppress surface dark current.

Document WO 97/36323 A (Advanced Micro devices inc [US] - 2 October 1997) discloses different methods for doping the edges of sidewalls of trenches. In this document, the sidewalls spacers are always formed first and then the doped region.

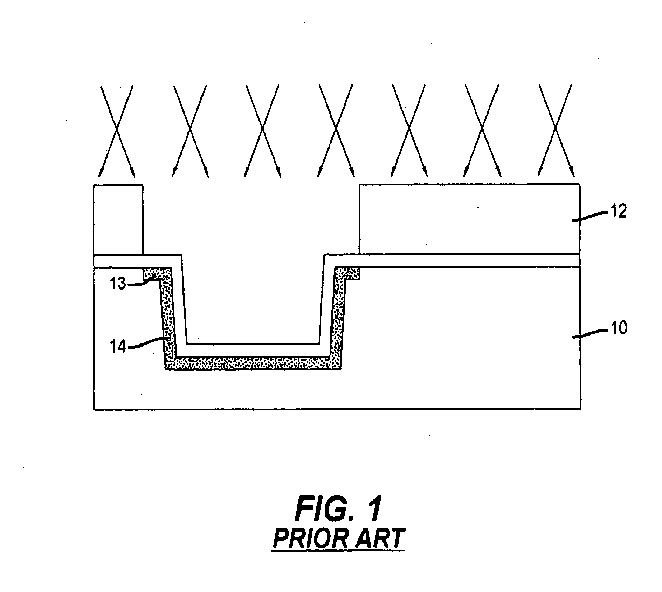

**FIG. 1** shows a cross-sectional view of a semiconductor substrate with a shallow trench isolation region according to the prior art. Substrate **10** includes a STI having a trench with corner implants **13** and sidewall implants **14.** One conventional method for fabricating corner implants **13** requires the formation and patterning of photoresist mask **12** on the device and the implantation of dopants (represented by arrows) into the corners of the shallow trench. Unfortunately, the formation and patterning of photoresist mask **12** creates an additional processing step in the manufacture of semiconductor devices.

Another method to form corner implants **13** is to remove a hard mask (not shown) from the sidewalls and corners of the shallow trench region of the semiconductor substrate and then simultaneously implant both the sidewalls and corners. Unfortunately, subsequent etches performed during the fabrication process can create undesirable silicon pits at the corner implants of the STI.

Therefore, there exists a need in image sensors to reduce the surface dark current in the sidewall implant.

Furthermore, there exists a need to provide a method for forming a shallow trench isolation that is self-aligned.

Additionally, there exists a need for forming corner implants that does not create silicon pits in the STI corner during subsequent processing of the image sensor.

### SUMMARY

The present invention is directed to overcoming one or more of the problems set forth above. The present invention relates to a method for fabricating an image sensor with corner implants in the shallow trench isolation regions. The method includes the steps of forming a first hard mask layer of over an etch-stop layer on a semiconductor substrate and providing a photoresist mask over the hard mask layer. The photoresist mask is patterned to create an opening and the portion of the first hard mask layer exposed in the opening is etched down to the etch-stop layer. A first dopant is then implanted into the semiconductor substrate through the exposed etch-stop layer. The photoresist mask is removed and a second hard mask layer is formed on the remaining structure and etched to create sidewall spacers along the side edges of the first hard mask layer. The etch stop layer and the semiconductor substrate positioned between the sidewall spacers are then etched to create a trench and a second dopant implanted into the side and bottom walls of the trench. The trench is then typically filled with a dielectric material to create a shallow trench isolation region in the semiconductor substrate.

The present advantage has the advantage of reducing the surface dark current by forming corner implants that do not cause silicon pitting with a shallow trench isolation that is self-aligned.

### BRIEF DESCRIPTION OF THE DRAWINGS

The above and other objects, features, and advantages of the present invention will become more apparent when taken in conjunction with the following description and drawings wherein identical reference numerals have been used, where possible, to designate identical features that are common to the figures, and wherein:
**FIG. 1** shows a cross-sectional view of a semiconductor substrate with a shallow trench isolation region according to the prior art;
**FIG. 2** shows a cross-sectional view of a semiconductor substrate and a first hard mask layer in an embodiment in accordance with the invention;
**FIG. 3** shows a cross-sectional view of a semiconductor substrate with an etched first hard mask layer in an embodiment in accordance with the invention;
**FIG. 4** shows a cross-sectional view of a semiconductor substrate with a shallow implant in an embodiment in accordance with the invention;
**FIG. 5** shows a cross-sectional view of a semiconductor substrate with a second hard mask layer in an embodiment in accordance with the invention;
**FIG. 6** shows a cross-sectional view of a semiconductor substrate with an etched second hard mask layer in an embodiment in accordance with the invention;
**FIG. 7** shows a cross-sectional view of a semiconductor substrate with a shallow trench in an embodiment in accordance with the invention;
**FIG. 8** shows a cross-sectional view of a semiconductor substrate with a shallow trench isolation and side wall implants in an embodiment in accordance with the invention;
**FIG. 9a** shows a first cross-sectional view of a semiconductor substrate containing devices between two shallow trench isolations with sidewall implants in embodiments in accordance with the invention; and
**FIG. 9b** shows a second cross-sectional view of a semiconductor substrate containing devices between two shallow trench isolations with sidewall implants in embodiments in accordance with the invention.

### DETAILED DESCRIPTION

The present invention includes a method for forming corner implants in STI regions of an integrated circuit. The implant is self-aligned to the STI corner without the need for additional photoresist masking or exposing the STI corner, which can lead to silicon pitting. The present invention is described with reference to the accompanying drawings, in which exemplary embodiments of the invention are shown. The invention may, however, be embodied in may different forms and should not be construed as being limited to the embodiments set forth herein; rather, these embodiments are provided to fully convey the concept of the present invention to those skilled in the art. The drawings are not to scale and many portions are exaggerated for clarity.

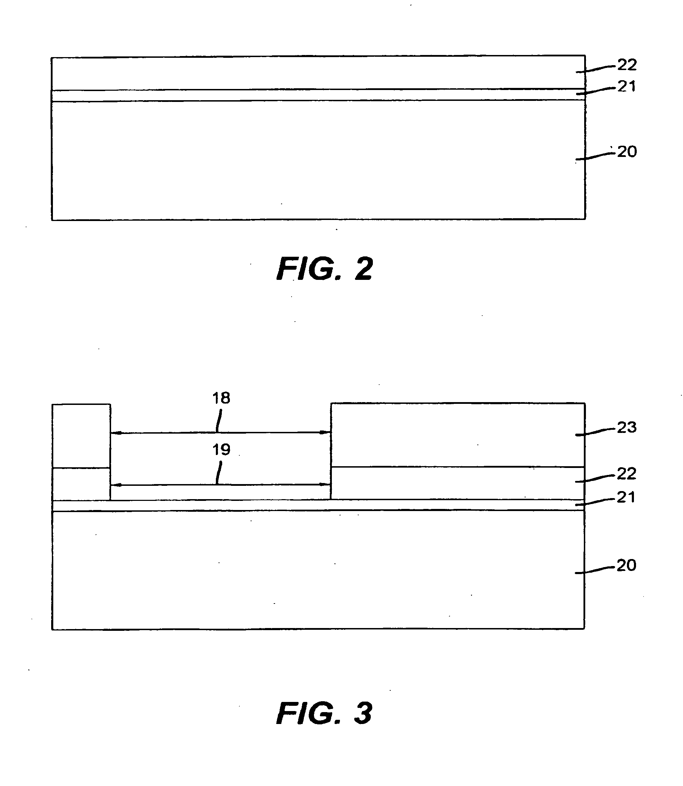

Referring to **FIG. 2****,** a cross-sectional view of a semiconductor substrate and a first hard mask layer in an embodiment in accordance with the invention is shown. Semiconductor substrate **20** is silicon, silicon carbide, silicon-on-insulator, silicon-germanium, gallium-nitride, or gallium-arsenide in one embodiment in accordance with the invention. Furthermore, semiconductor substrate **20** can be n-type, p-type or an undoped substrate. Additionally, semiconductor substrate **20** may optionally have an epitaxial layer (not shown) that is the same or opposite conductivity type as semiconductor substrate **20.** Semiconductor substrate **20** may also contain wells that are of the same or opposite conductivity type as either the epitaxial layer or semiconductor substrate **20** implanted therein.

Etch-stop layer **21** is formed on the surface of semiconductor substrate **20.** In one embodiment in accordance with the invention, etch-stop layer **21** is formed as a thin layer of silicon dioxide or polysilicon. A silicon dioxide etch-stop layer may be grown on the substrate in oxygen or steam typically at 800 - 1200°C. Alternatively, etch stop layer **21** may be deposited directly on the surface of semiconductor substrate **20** by oxide chemical vapor deposition. Oxide chemical vapor deposition is accomplished by a low-pressure low temperature deposition or a plasma enhanced chemical vapor deposition.

First hard mask layer **22** is deposited on etch-stop layer **21** via traditional processes such as low pressure chemical vapor deposition (LPCVD) or plasma enhanced chemical vapor deposition (PECVD). First hard mask layer **22** is configured as any mask layer that is deposited or grown on the device. Examples of a hard mask layer include, but are not limited to, silicon nitride, polysilicon and a metal film.

**FIG. 3** shows a cross-sectional view of a semiconductor substrate with an etched first hard mask layer in an embodiment in accordance with the invention. Photoresist mask **23** is coated onto first hard mask layer **22** and patterned to form opening **18.** An anisotropic etch is then performed to remove the portion of first hard mask layer **22** exposed in opening **18.** Opening **19** in first hard mask layer **22** is wider than the width of a shallow trench that will be formed in semiconductor substrate **20.**

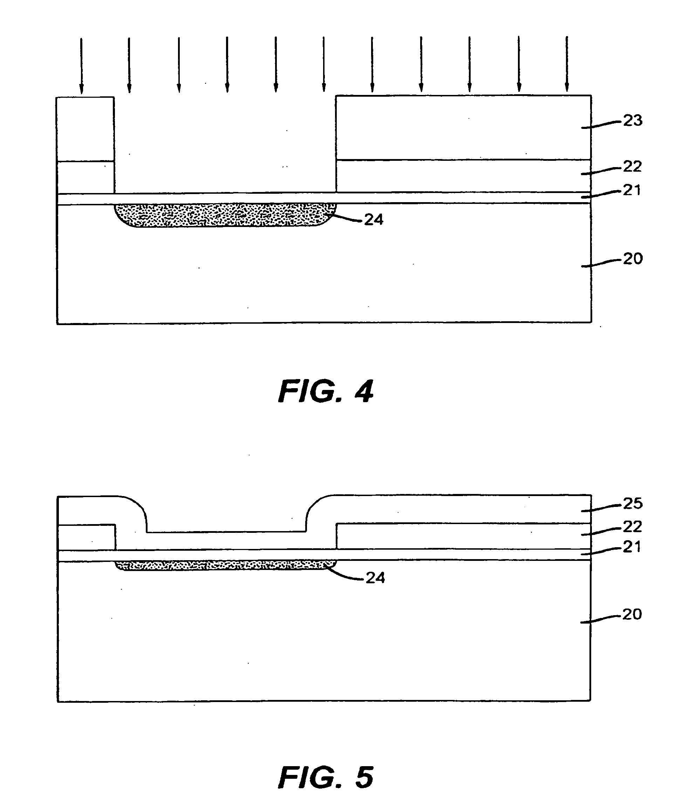

Referring to **FIG. 4****,** a cross-sectional view of a semiconductor substrate with a shallow implant in an embodiment in accordance with the invention is shown. Shallow implant **24** is typically implanted to a depth between 100 and 500A in an embodiment in accordance with the invention. Photoresist mask **23** and first hard mask layer **22** serve as a protective mask for the regions of the semiconductor substrate in which a shallow implant is not to be formed. Shallow implant **24** is a dopant having a conductivity type opposite the conductivity type of the photodetectors (not shown) in the image sensor. In one embodiment in accordance with the invention, the dopant is an n-type dopant such as phosphorus, arsenic, or antimony. In another embodiment in accordance with the invention, the dopant is a p-type dopant such as boron, aluminum, gallium or indium.

The implant energy depends on the particular dopant used and is typically between 5-200KeV for an implant depth typically between 100 and 500A. The implant profile distribution is such that the implant dopant remains near the surface of substrate **20.** If thermal processing occurs after implantation the dopant will diffuse away from the initial implant area. This diffusion is accounted for when choosing the initial implant depth and concentration of the elementary dopant.

Photoresist mask **23** is then removed by an oxygen ashing process, wet sulfuric acid mixed with peroxide, or solvent chemistry methods. If adequate thickness is used for first hard mask layer **22,** photoresist mask **23** is removed and first hard mask layer **22** is the protective mask for the implant in an embodiment in accordance with the invention. In another embodiment in accordance with the invention, shallow implant **24** is formed in substrate **20** before first hard mask layer **22** is ansiotropically etched.

**FIG. 5** shows a cross-sectional view of a semiconductor substrate with a second hard mask layer in an embodiment in accordance with the invention. Second hard mask layer **25** is deposited on first hard mask layer **22** and the exposed portion of etch-stop layer **21.** Second hard mask layer **25** may be of the same or different material than first hard mask layer **22.** Second hard mask layer **25** is of a material that has a slow removal rate during an STI anisotropic etch when compared to the silicon removal rate in an embodiment in accordance with the invention.

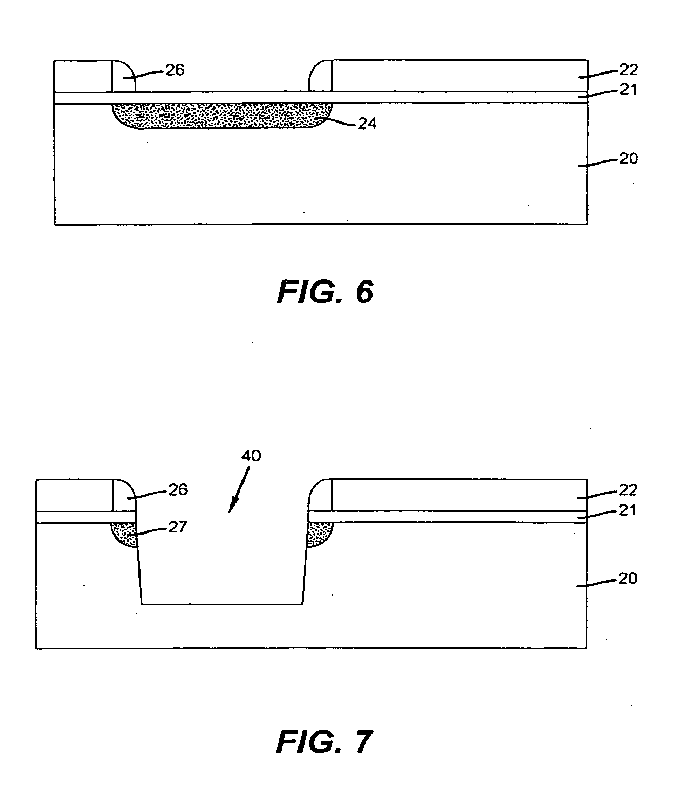

Referring to **FIG. 6****,** a cross-sectional view of a semiconductor substrate with an etched second hard mask layer in an embodiment in accordance with the invention is shown. An anisotropic etch, such as plasma etching, is used to form sidewall spacers **26** along the sides of first hard mask layer **22.** Sidewall spacers 26 are positioned over the perimeter portions of shallow implant **24.** Sidewall spacers **26** each typically have a width between 0.05 and 0.2µm in an embodiment in accordance with the invention. The width of sidewall spacers **26** is primarily controlled by the thickness of second hard mask layer **25** (see FIG. 5).

**FIG. 7** shows a cross-sectional view of a semiconductor substrate with a shallow trench in an embodiment in accordance with the invention. Shallow trench **40** is formed by anisotropically etching through shallow implant **24** and into semiconductor substrate **20.** Shallow trench **40** is formed in the area between sidewall spacers **26** in semiconductor substrate **20.** Corner implants **27** are the only portions of shallow implant **24** to remain in substrate **20.** By etching through opening **19** in second hard mask layer **25,** the inside edges of corner implants **27** are self-aligned with the inside edge of second hard mask layer **25.**

In one embodiment in accordance with the invention, shallow trench **40** typically has a depth between 0.3 and 0.5µm and a width between 0.15 and 0.6µm. The width of shallow trench **40** should be as small as possible to minimize the amount of semiconductor substrate used for the STI regions. Minimizing the size of the STI regions advantageously increases the amount of substrate that is available for photodetectors in an image sensor.

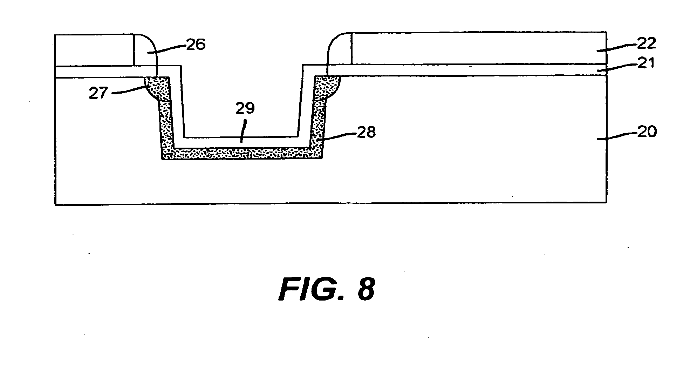

Referring to **FIG. 8****,** the sidewalls and bottom of shallow trench **40** are implanted with implant dopant **28.** Implant dopant **28** is typically implanted between 0 and 100A from the exposed surface of the substrate **20** and the concentration of implant dopant **28** is typically between 10¹²-10¹³ atoms/cm² in an embodiment in accordance with the invention. This implant is usually done at an angle and quaded (i.e., done at four separate wafer rotations ninety degrees apart) so that implant dopant **28** is implanted into all four sides and the bottom of shallow trench **40.**

Implant dopant **28** is of the same conductivity type as the corner implants **27.** In one embodiment in accordance with the invention, implant dopant **28** is also the same dopant as the shallow implant **24** dopant. Implant dopant **28** can be an n-type dopant such as phosphorus, arsenic, or antimony, or a p-type dopant such as boron, aluminum, gallium or indium.

Dielectric layer **29** is typically formed on the regions of the silicon implanted with dopant **28** by a low-pressure chemical vapor deposition, an atmospheric pressure chemical vapor deposition, a plasma enhanced chemical vapor deposition, or a high density plasma deposition. Examples of a dielectric material that can be used for dielectric layer **29** include, but are not limited to, a liner oxide or nitride. Dielectric layer **29** can be grown or deposited either prior to or after the implantation of implant dopant **28.** Isolation trench **40** is then filled with a dielectric material (not shown).

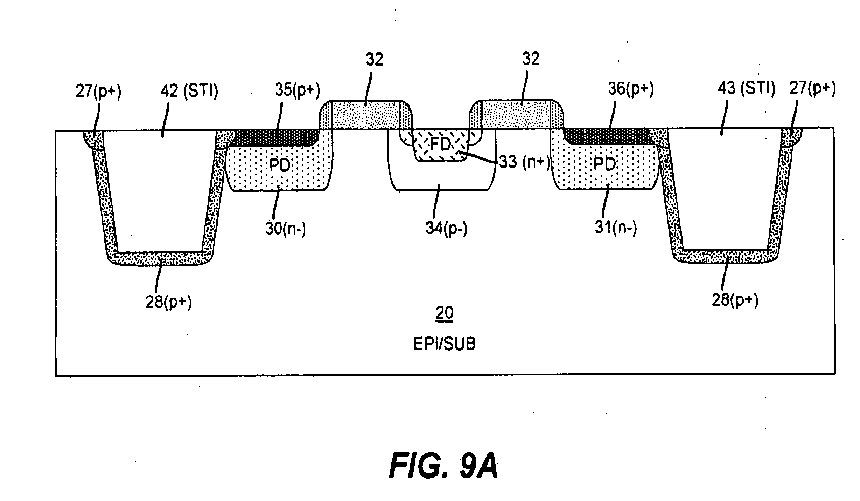

Referring to **FIG. 9a****,** a first cross-sectional view of a semiconductor substrate containing devices between two shallow trench isolations with sidewall implants in embodiments in accordance with the invention is shown. STI regions **42, 43** are shown adjacent to photodetectors **30, 31,** respectively. Photodetectors **30, 31** have a conductivity type that is opposite the conductivity type of implant dopant **28** and corner implants **27.** When transfer gate **32** is pulsed, charge is transferred from one photodetector (e.g., photodetector **30**) into floating diffusion **33,** also referred to as a sensing node, contained in well **34.** The signal is then sensed by the pixel amplifier (not shown) and fed into the downstream circuitry (not shown) outside of the pixel array. Floating diffusion **33** has a conductivity type that is opposite the conductivity type of implant dopant **28** and corner implants **27.**

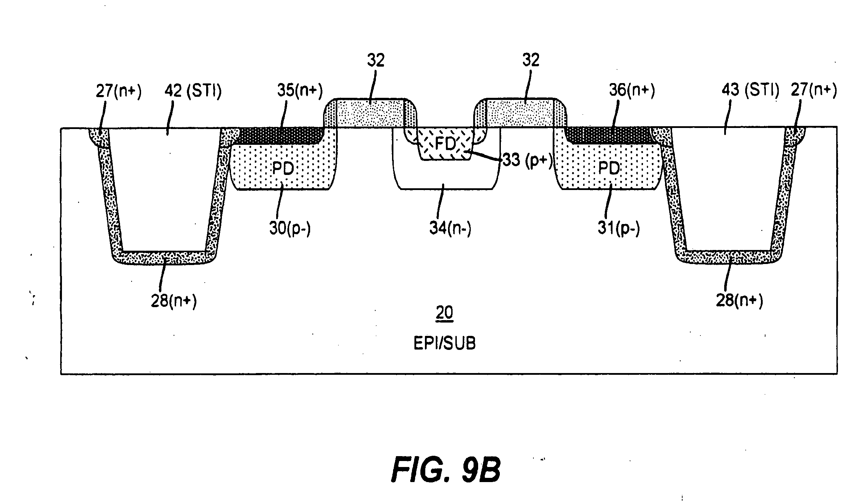

**FIG. 9b** shows a second cross-sectional view of a semiconductor substrate containing devices between two shallow trench isolations with sidewall implants in embodiments in accordance with the invention. The conductivity type of corner implants **27,** implant dopant **28,** photodetectors **30, 31,** floating diffusion **33,** well **34,** and pining layers **35, 36** is reversed with respect to the conductivity types shown in **FIG. 9a****.**

The first hard mask layer and second hard mask layer have been removed from the structure shown in **FIGS. 9a** and **9b****.** However, it is understood that these layers may alternatively remain in the final structure. Although an image sensor with two shared photodetectors is shown in **FIGS. 9a** and **9b** it is understood that any number of photodetectors may be used. Typically one, two or four photodetectors can be connected to a single floating diffusion by transfer gates. The photodetectors are usually formed at a depth that is less than the shallow trench.

### PARTS LIST

- **10**: semiconductor substrate
- **11**: oxide film layer
- **12**: photoresist mask
- **13**: corner implants
- **14**: side wall implants
- **18**: opening in photoresist mask
- **19**: opening in first hard mask layer
- **20**: semiconductor substrate
- **21**: etch-stop layer
- **22**: first hard mask layer
- **23**: photoresist mask
- **24**: shallow implant
- **25**: second hard mask layer
- **26**: sidewall spacers
- **27**: corner implants
- **28**: implant dopant
- **29**: dielectric layer
- **30**: photodetector
- **31**: photodetector
- **32**: transfer gate
- **33**: floating diffusion
- **34**: well
- **35**: pining layer
- **36**: pining layer
- **40**: shallow trench
- **42**: shallow trench isolation
- **43**: shallow trench isolation

## Claims

1. A method for forming an isolation region in a semiconductor substrate to isolate devices formed in the substrate, comprising in order the following steps:
a) forming a shallow implant (24) in a portion of the semiconductor substrate (20) by implanting a first dopant through an opening (19) in a first hard mask layer (22);
b) forming a second hard mask layer (25) over the portion of the semiconductor substrate (20) and the first hard mask layer (22);
c) etching the second hard mask layer (25) to form sidewall spacers (26) along the sides of the first hard mask layer (22), wherein each sidewall spacer (26) overlies a portion of the shallow implant (24) in the semiconductor substrate (20); and
d) etching into the semiconductor substrate (20) between the sidewall spacers (26) to form an isolation trench (40) and corner implants (27).

2. The method of claim 1, further comprising:
forming an etch-stop layer (21) over the semiconductor substrate surface;
forming the first hard mask layer (22) over the etch-stop layer (21);
providing a photoresist mask layer (23) over the first hard mask layer (22);
patterning the photoresist mask layer (23) to form an opening (18) in the photoresist mask layer (23) ; and
etching the first hard mask layer (22) through the opening (18) in the photoresist mask layer (23) to form the opening (19) in the first hard mask layer (22).

3. The method of claim 1 further comprising:
implanting a second dopant (28) into the side and bottom walls of the isolation trench (40).

4. The method of claim 3 further comprising forming a conformal insulating layer (29) over the side and bottom walls of the isolation trench (40).

5. The method of claim 3 wherein the second dopant (28) has the same conductivity type as the first dopant.

6. The method of claim 2 further comprising the step of forming a photodetector (30, 31) in the semiconductor substrate (20) for capturing light and converting it to a charge, wherein the photodetector (30, 31) is laterally adjacent the isolation trench (40).

7. The method of claim 2 wherein the step of etching the semiconductor substrate (20) between the sidewall spacers (26) to form an isolation trench (40) and corner implants (27) self aligns an inside edge of each corner implant (27) with an inside edge of a respective sidewall spacer (26).

## Patentansprüche

1. Verfahren zum Ausbilden eines Isolierbereichs in einem Halbleitersubstrat, um in dem Substrat ausgebildete Einrichtungen zu isolieren, mit folgenden Schritten in der angegebenen Reihenfolge:
a) Ausbilden eines flachen Implantats (24) in einem Abschnitt des Halbleitersubstrats (20) durch Implantieren eines ersten Dotierungsmittels durch eine Öffnung (19) in einer ersten harten Maskenschicht (22);
b) Ausbilden einer zweiten harten Maskenschicht (25) über dem Abschnitt des Halbleitersubstrats (20) und der ersten harten Maskenschicht (22);
c) Ätzen der zweiten harten Maskenschicht (25) zum Ausbilden von Seitenwand-Abstandshaltern (26) entlang den Seiten der ersten harten Maskenschicht (22), worin jeder Seitenwand-Abstandshalter (26) einen Abschnitt des flachen Implantats (24) im Halbleitersubstrat (20) überlagert; und
d) Ätzen in das Halbleitersubstrat (20) zwischen den Seitenwand-Abstandshaltern (26) zum Ausbilden eines Isolierschlitzes (40) und von Eckimplantaten (27).

2. Verfahren nach Anspruch 1 mit den Schritten:
Ausbilden einer Ätzstoppschicht (21) über der Oberfläche des Halbleitersubstrats;
Ausbilden der ersten harten Maskenschicht (22) über der Ätzstoppschicht (21);
Bereitstellen einer Fotolackmaskenschicht (23) über der ersten harten Maskenschicht (22);
Versehen der Fotolackmaskenschicht (23) mit einem Muster zum Ausbilden einer Öffnung (18) in der Fotolackmaskenschicht (23); und
Ätzen der ersten harten Maskenschicht (22) durch die Öffnung (18) in der Fotolackmaskenschicht (23) zum Ausbilden der Öffnung (19) in der ersten harten Maskenschicht (22).

3. Verfahren nach Anspruch 1, mit dem Schritt:
Implantieren eines zweiten Dotierungsmittels (28) in die seitliche und untere Wandung des Isolierschlitzes (40).

4. Verfahren nach Anspruch 3, mit dem Schritt des Ausbildens einer gleichförmigen Isolierschicht (29) über der seitlichen und unteren Wandung des Isolierschlitzes (40).

5. Verfahren nach Anspruch 3, worin das zweite Dotierungsmittel (28) vom gleichen Leitfähigkeitstyp ist wie das erste Dotierungsmittel.

6. Verfahren nach Anspruch 2, mit dem Schritt des Ausbildens eines Fotodetektors (30, 31) im Halbleitersubstrat (20) zum Einfangen von Licht und zum Umwandeln des Lichts in eine Ladung, worin der Fotodetektor (30, 31) dem Isolierschlitz (40) seitlich benachbart ist.

7. Verfahren nach Anspruch 2, worin beim Schritt des Ätzens des Halbleitersubstrats (20) zwischen den Seitenwand-Abstandshaltern (26) zum Ausbilden eines Isolierschlitzes (40) und von Eckimplantaten (27) eine Innenkante eines jeden Eckimplantats (27) mit einer Innenkante eines entsprechenden Seitenwand-Abstandhalters (26) selbsttätig ausgerichtet wird.

## Revendications

1. Procédé pour former une zone isolante dans un substrat semi-conducteur afin d'isoler les dispositifs formés dans le substrat, comprenant dans l'ordre les étapes suivantes :
a) formation d'un implant peu profond (24) dans une portion du substrat semi-conducteur (20) en implantant un premier dopant à travers une ouverture (19) dans un premier masque dur (22) ;
b) formation d'un deuxième masque dur (25) au-dessus de la portion du substrat semi-conducteur (20) et du premier masque dur (22) ;
c) gravure du deuxième masque dur (25) pour former des éléments d'espacement latéraux (26) le long des bords du premier masque dur (22), où chaque élément d'espacement latéral (26) recouvre une portion de l'implant peu profond (24) dans le substrat semi-conducteur (20) ; et
d) gravure dans le substrat semi-conducteur (20) entre les éléments d'espacement latéraux (26) pour former une tranchée isolante (40) et des implants d'angle (27).

2. Procédé selon la revendication 1, comprenant aussi :
la formation d'une couche d'arrêt de gravure (21) au-dessus de la surface du substrat semi-conducteur ;
la formation du premier masque dur (22) au-dessus de la couche d'arrêt de gravure (21) ;
l'application d'un masque de photoresist (23) au-dessus du premier masque dur (22) ;
le modelage du masque de photoresist (23) pour former une ouverture (18) dans le masque de photoresist (23) ; et
la gravure du premier masque dur (22) à travers l'ouverture (18) dans le masque de photoresist (23) pour former l'ouverture (19) dans le premier masque dur (22).

3. Procédé selon la revendication 1, comprenant aussi :
l'implantation d'un deuxième dopant (28) dans les parois latérales et le fond de la tranchée isolante (40).

4. Procédé selon la revendication 3, comprenant aussi la formation d'une couche isolante conforme (29) au-dessus des parois latérales et du fond de la tranchée isolante (40).

5. Procédé selon la revendication 3, dans lequel le deuxième dopant (28) a le même type de conductivité que le premier dopant.

6. Procédé selon la revendication 2, comprenant aussi l'étape de formation d'un photodétecteur (30, 31) dans le substrat semi-conducteur (20) pour capturer la lumière et la convertir en une charge, dans lequel le photodétecteur (30, 31) est latéralement adjacent à la tranchée isolante (40).

7. Procédé selon la revendication 2, dans lequel l'étape de gravure du substrat semi-conducteur (20) entre les éléments d'espacement latéraux (26) pour former une tranchée isolante (40) et des implants d'angle (27) aligne automatiquement un bord intérieur de chaque implant d'angle (27) avec un bord intérieur d'un élément d'espacement latéral correspondant (26).
